# EUROPÄISCHE PATENTSCHRIFT

(11) **EP 0 465 693 B1**
(45) Veröffentlichungstag und Bekanntmachung des Hinweises auf die Patenterteilung: **06.10.1993**
(21) Anmeldenummer: 90113092.2
(22) Anmeldetag: 09.07.1990
(51) Int. Cl.: H05K 7/20

(54) **Elektrisch isolierender Schaltungsträger mit integrierten Kühlmitteln**
Electrical insulating printed circuit board with integrated cooling means
Plaquette à circuit imprimé isolant aux moyens intégrés de refroidissement

(43) Veröffentlichungstag der Anmeldung: 15.01.1992
(73) Patentinhaber: SIEMENS AKTIENGESELLSCHAFT, 80333 München (DE)
(72) Erfinder: Kasowski, Hermann, Dipl.-Ing. (FH), D-8450 Amberg (DE); Schönberger, Eduard, Dipl.-Ing. (FH), D-8450 Amberg (DE)

(56) Entgegenhaltungen:
- DE-A- 3 147 789
- DE-A- 3 416 348
- GB-A- 2 164 499
- US-A- 4 811 165
- IBM TECHNICAL DISCLOSURE BULLETIN Band 28, Nr. 12, Mai 1986, Seiten 5565-5567, New York, US; "Ground plane thermal conduction brackets"

## Beschreibung

Die Erfindung betrifft einen elektrisch isolierenden Schaltungsträger mit von seiner Oberfläche abstehenden Elementen, die einstückig mit dem Schaltungsträger verbunden sind.

Aus der DE-OS 32 22 178 ist ein elektrisch isolierender Schaltungsträger, der einstückig mit Aufnahmen verbunden und mit diesen hergestellt ist, bekannt. Dieser Träger wird nachträglich im Heißprägeverfahren mit metallischen Leitern zur elektrischen Stromleitung versehen. Hierbei dienen starre Rippen, Stege, Stifte, Säulen oder Konsolen der Bauelementeaufnahme. Mit diesem Träger wird die Aufgabe gelöst, nicht nur die Verdrahtung, sondern auch die Montage elektrischer Bauelemente sowie mechanischer Baugruppen zu vereinfachen und zu rationalisieren. Hinweise auf eine hierin zu integrierende Kühlung der Bauelemente sind jedoch nicht angegeben.

Weiterhin ist bekannt, zur Kühlung von Bauelementen auf einer Leiterplatte Kühlkörper zu verwenden. Die DE-OS 34 16 348 offenbart eine Leiterplatte mit einer Ausnehmung, durch die ein Zapfen eines Kühlkörpers geführt ist. Mit dem Zapfen wird ein auf der Leiterplatte angeordnetes, elektrisches Bauelement wärmeleitend verbunden. Die Verwendung eines Kühlkörpers als zusätzliches Element ist bekannt. Allerdings bedeutet der Zapfen an dem Kühlkörper als wärmeleitende Brücke zwischen dem Bauelement und dem eigentlichen Kühlkörper eine Vereinfachung.

Hiervon ausgehend besteht die Aufgabe, bei elektrisch isolierenden Schaltungsträgern der obengenannten Art die Kühlung von auf dem Schaltungsträger angeordneten elektrischen Bauelementen mit guter Wirkung und durch einfache Bauweise zu verbessern. Dies wird dadurch gelöst, daß ein Teil der im wesentlichen flächig ausgebildeten Elemente metallisierte Bahnen und/oder Flächen aufweist, die zur Abführung und Weiterleitung der Verlustwärme durch auf dem Schaltungsträger angeordnete und in Betrieb befindliche elektrische Bauelemente dienen. Die Elemente sind zweckmäßigerweise als Rippen, Stege oder Zapfen ausgeführt. Besteht zwischen einem Teil der Bauelemente und der metallisierten Fläche eines Elements direkter Berührungskontakt, so ist die Abführung der Verlustwärme von den Bauelementen besonders wirksam. Eine vorteilhafte Ausführung ist gegeben, wenn ein Teil der metallisierten Elemente untereinander durch ein Wärmeleitblech miteinander verbunden ist, da ein solches Wärmeleitblech nicht nur eine gute Wärmebrücke darstellt, sondern auch nachträglich den räumlichen Gegebenheiten entsprechend geformt werden kann. Weiterhin ist es von Vorteil, wenn auf dem Schaltungsträger wenigstens eine Baugruppe elektrisch angeschlossen ist und diese mindestens ein metallisiertes Element großflächig zur Wärmeleitung kontaktiert und von diesem Element als Ort einer Wärmequelle eine Verbindung über wenigstens ein Wärmeleitblech zu anderen, als Wärmesenke dienenden Kühlelementen auf dem Schaltungsträger besteht, wobei die von den Kühlelementen aufgenommene Wärme an die Umgebungsluft abgestrahlt wird. Die auf diese Weise vorgenommene Kühlung der Baugruppe erweist sich als besonders einfach und wirksam. Es ist außerdem vorteilhaft, wenn die Kühlelemente integraler Bestandteil des Schaltungsträgers sind, z.B. in Form von angeformten Rippen, Stegen oder Zapfen. Derartige Kühlelemente werden, wie die zuvor schon genannten Elemente, in einem Arbeitsprozeß durch Spritzguß des Schaltungsträgers, z.B. einer Leiterplatte hergestellt und erfordern demgemäß einen weitaus geringeren Kostenaufwand wie z.B. eine Lösung mit zusätzlichen Kühlkörpern, die zudem noch montiert werden müssen. Um die Abführung von Verlustwärme aus Baugruppen mit z.B. Leiterplatten zu verbessern, ist es von Vorteil, wenn die Baugruppen nach außen jeweils eine Kühlkapsel aus Metallblech aufweisen, die das metallisierte Element auf dem Schaltungsträger großflächig berührt.

Ausführungsformen der Erfindung werden im folgenden anhand einer Zeichnung näher erläutert.

Es zeigen:
- FIG 1: einen elektrisch isolierenden Schaltungsträger in perspektivischer Darstellung,
- FIG 2: einen Querschnitt eines Schaltungsträgers mit Einsatz eines Wärmeleitbleches,
- FIG 3: eine Rippe als integraler Bestandteil eines Schaltungsträgers mit daran angebrachtem Kühlkörper,
- FIG 4: eine Draufsicht auf einen Schaltungsträger mit Stegen und einem Wärmeleitblech als Mittel zur Abführung von Verlustwärme einer Baugruppe.

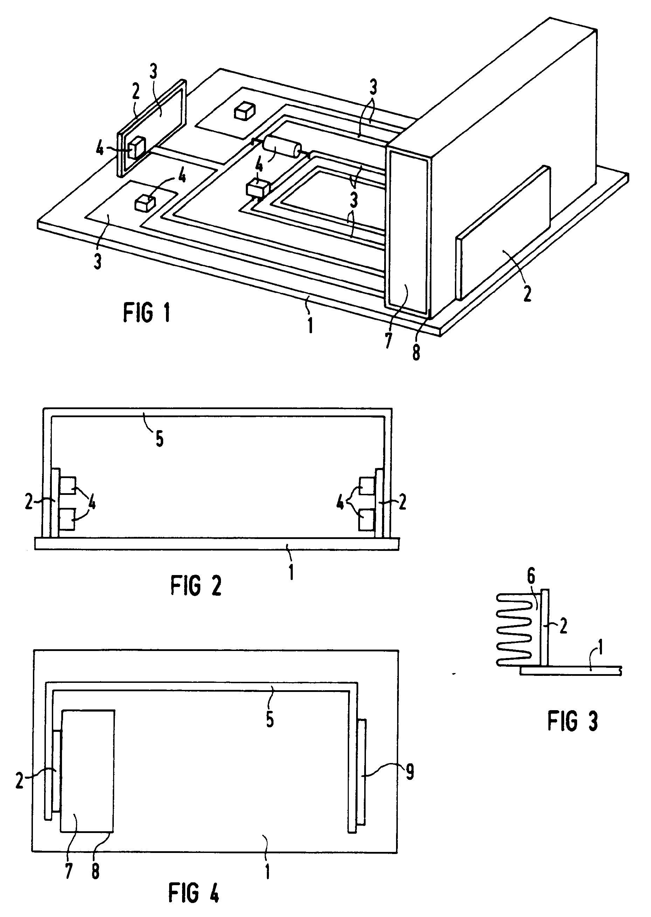

FIG 1 zeigt einen elektrisch isolierenden Schaltungsträger 1 mit an seiner Oberfläche angeformten Rippen 2. Der Schaltungsträger 1 und die Rippen 2 weisen metallisierte Bahnen und Flächen 3 auf. Mit diesen sind auf dem Schaltungsträger 1 angeordnete Bauelemente 4 wenigstens zum Teil verbunden. Dadurch wird die von den Bauelementen 4 erzeugte Verlustwärme über die Bahnen und Flächen 3, insbesondere auf den Rippen 2 abgeführt. Die Rippen 2 haben somit die gleiche Funktion wie die Kühlrippen von Kühlkörpern, sind jedoch hier integraler Bestandteil des Schaltungsträgers 1. Eine besonders gute Wärmeabführung ist möglich, wenn das Bauelement 4 die Rippe 2 großflächig kontaktiert und z.B. direkt auf ihr befestigt ist. Statt eines Bauelementes 4 kann aber auch eine Baugruppe 7 über ihre äußere Kühlkapsel 8 aus Metallblech mit einer Rippe großflächig in Verbindung stehen. Zur Weiterleitung der Verlustwärme der Baugruppe 8 kann an derselben Rippe 2 ein Wärmeleitblech 5 angebracht werden, wie es in FIG 4 dargestellt ist. Hier wird der Wärmetransport über das Wärmeleitblech 5 zu einer weiteren als Kühlelement 9 ausgebildeten Rippe vorgenommen, die z.B. gemäß FIG 3 zudem noch einen gesonderten Kühlkörper 6 aufweisen kann.

FIG 2 zeigt zwei an dem Schaltungsträger 1 angeformte Rippen 2, die metallisiert sind und an der Oberfläche Bauelemente 4 tragen. Abhängig vom Betrieb erzeugen die Bauelemente 4 unterschiedliche Verlustwärme. Durch das beide Rippen 2 verbindende Wärmeleitblech 5 ist ein Ausgleich der Wärme zwischen beiden Rippen 2 möglich, so daß eine Überhitzung der Bauelemente vermieden werden kann. Z.B. kann je nach Betriebsart, d.h. dem Anfall an Verlustwärme durch die Bauelemente 4 die eine Rippe 2 einmal als Wärmequelle und zum anderen als Wärmesenke gegenüber der anderen Rippe 2 dienen, so daß die Wärmetransportrichtung sich entsprechend ändern wird. Durch das Wärmeleitblech 5 wird erreicht, daß stets beide Rippen 2 an der Abgabe der gesamten Verlustleistung durch sämtliche Bauelemente 4 auf den Rippen 2 an die Umgebungsluft beteiligt sind. Selbstverständlich ist jede Kombination der bei den Figuren vorkommenden Merkmale möglich.

## Patentansprüche

1. Elektrisch isolierender Schaltungsträger (1) mit von seiner Oberfläche abstehenden Elementen (2) die einstückig mit dem Schaltungsträger (1) verbunden sind, **dadurch** **gekennzeichnet,** daß ein Teil der im wesentlichen flächig ausgebildeten Elemente (2) metallisierte Bahnen und/oder Flächen (3) aufweist, die zur Abführung und Weiterleitung der Verlustwärme durch auf dem Schaltungsträger (1) angeordnete und in Betrieb befindliche elektrische Bauelemente (4) dienen.

2. Elektrisch isolierender Schaltungsträger nach Anspruch 1, **dadurch gekennzeichnet**, daß die Elemente (2) als Rippen, Stege oder Zapfen ausgeführt sind.

3. Elektrisch isolierender Schaltungsträger nach Anspruch 1 oder 2, **dadurch gekennzeichnet**, daß zwischen einem Teil der Bauelemente (4) und der metallisierten Fläche (3) eines Elements direkter Berührungskontakt besteht.

4. Elektrisch isolierender Schaltungsträger nach einem der vorangehenden Ansprüche, **dadurch gekennzeichnet**, daß ein Teil der metallisierten Elemente (2) untereinander durch ein Wärmeleitblech (5) miteinander verbunden ist.

5. Elektrisch isolierender Schaltungsträger nach einem der vorangehenden Ansprüche, **dadurch gekennzeichnet**, daß auf dem Schaltungsträger (1) wenigstens eine Baugruppe (7) elektrisch angeschlossen ist und diese mindestens ein metallisiertes Element (2) großflächig zur Wärmeleitung kontaktiert und daß von diesem Element als Ort einer Wärmequelle eine Verbindung über wenigstens ein Wärmeleitblech (5) zu anderen, als Wärmesenke dienenden Kühlelementen (9) auf dem Schaltungsträger (1) besteht.

6. Elektrisch isolierender Schaltungsträger nach Anspruch 5, **dadurch gekennzeichnet**, daß die Kühlelemente (9) integraler Bestandteil des Schaltungsträgers (1) sind, z.B. in Form von angeformten Rippen, Stegen oder Zapfen.

7. Elektrisch isolierender Schaltungsträger nach Anspruch 5 oder 6, **dadurch gekennzeichnet**, daß die Baugruppen (7) nach außen jeweils eine Kühlkapsel (8) aus Metallblech aufweisen, die das metallisierte Element (2) auf dem Schaltungsträger großflächig berührt.

## Claims

1. Electrically insulating circuit carrier (1) with elements (2) which project from its upper surface and which are connected in one piece with the circuit carrier (1), characterised in that a portion of the elements (2), which are formed so as to be substantially planar, has metal-coated tracks and/or surfaces (3) which are used to dissipate and redirect the heat loss through electrical components (4) which are arranged on the circuit carrier (1) and which are in operation.

2. Electrically insulating circuit carrier according to claim 1, characterised in that the elements (2) are realized as ribs, cross-pieces or pegs.

3. Electrically insulating circuit carrier according to claim 1 or 2, characterised in that there is direct touch-contact between a portion of the components (4) and the metal-coated surface (3) of an element.

4. Electrically insulating circuit carrier according to one of the preceding claims, characterised in that portions of the metal-coated elements (2) are interconnected by means of a heat-conducting sheet (5).

5. Electrically insulating circuit carrier according to one of the preceding claims, characterised in that at least one assembly (7) is electrically connected on the circuit carrier (1) and said assembly contacts at least one metal-coated element (2) over a large surface area for the purpose of heat conduction and in that there is a connection from this element, as a heat source location, by way of at least one heat-conducting sheet (5), to other cooling elements (9), on the circuit carrier (1), which are used as a heat sink.

6. Electrically insulating circuit carrier according to claim 5, characterised in that the cooling elements (9) are an integral part of the circuit carrier (1), for example in the form of ribs, cross-pieces or pegs which are pre-formed thereon.

7. Electrically insulating circuit carrier according to claim 5 or 6, characterised in that the assemblies (7) have on the outside, in each case, a cooling capsule (8) of sheet metal which contacts the metal-coated element (2) on the circuit carrier over a large surface area.

## Revendications

1. Support électriquement isolant (1) pour circuits, comportant des éléments (2) qui font saillie sur sa surface et sont raccordés d'un seul tenant au support (1) pour circuits, caractérisé par le fait qu'une partie des éléments (2) réalisés avec une forme sensiblement plate comporte des bandes et/ou des surfaces métallisées (3), qui servent à évacuer et à transmettre la chaleur dissipée par des composants électriques en fonctionnement (4) disposés sur le support (1) pour circuits.

2. Support électriquement isolant pour circuits suivant la revendication 1, caractérisé par le fait que les éléments (2) sont réalisés sous la forme de nervures, de barrettes ou de tiges.

3. Support électriquement isolant pour circuits suivant la revendication 1 ou 2, caractérisé par le fait qu'il existe un contact direct entre une partie des composants (4) et la surface métallisée (3) d'un élément.

4. Support électriquement isolant pour circuits suivant l'une des revendications précédentes, caractérisé par le fait qu'une partie des éléments métallisés (2) sont raccordés entre eux par une tôle thermoconductrice (5).

5. Support électriquement isolant pour circuits suivant l'une des revendications précédentes, caractérisé par le fait qu'au moins un module (7) est raccordé électriquement sur le support (1) pour circuits et que ce module est en contact avec au moins un élément métallisé (2) sur une surface étendue pour la conduction thermique, et qu'une liaison entre cet élement en tant qu'emplacement d'une source de chaleur et d'autres éléments de refroidissement (9) utilises comme puits de chaleur, sur le support (1) pour circuits, est établie par l'intermédiaire d'au moins une tôle thermoconductrice (5).

6. Support électriquement isolant pour circuit suivant la revendication 5, caractérisé par le fait que les éléments de refroidissement sont partie intégrante du support (1) pour circuit, par exemple sous la forme de nervures, de barrettes ou de tiges, qui en sont issue.

7. Support électriquement isolant pour circuit suivant la revendication 5 ou 6, caractérisé par le fait que les modules (7) comportent, vers l'extérieur, respectivement une capsule de refroidissement en tôle métallique, qui touche sur une grande surface l'élément (2) métallisé, sur le support pour circuit.
